# EUROPEAN PATENT SPECIFICATION

(11) **EP 0 340 720 B1**
(45) Date of publication and mention of the grant of the patent: **20.09.1995**
(21) Application number: 89107928.7
(22) Date of filing: 02.05.1989
(51) Int. Cl.: H03K 19/0175

(54) **Interface circuit**
Schnittstellenschaltung
Circuit d'interface

(30) Priority: 02.05.1988 JP 109316/88
(43) Date of publication of application: 08.11.1989
(73) Proprietor: KABUSHIKI KAISHA TOSHIBA, Kawasaki-shi, Kanagawa-ken 210 (JP)
(72) Inventor: Nakamura, Michinori Intellectual Property Division, Minato-ku Tokyo 105 (JP)
(74) Representative: Lehn, Werner, Dipl.-Ing.

(56) References cited:
- WO-A-89/01262
- DE-A- 3 518 413
- PATENT ABSTRACTS OF JAPAN, vol. 5, no. 179 (E-82)(851), 17th November 1981;&JP-A-56 106 427
- BAUTEILE REPORT, vol. 11, no. 4, 1973, pages 92-96; H. LIEDL: "Pegel-Interfacezwischen den Schaltungssystemen TTL, LSL und MOS"
- G.M. GLASFORD: "ANALOG ELECTRONIC CIRCUITS", 1986, pages 182-185, Prentice/Hall International, Inc;
- Siemens Databook 1974/75 Band 1, Digital Schaltungen, p480
- PRECISION MONOLITHICS 1977-1978 LINEAR & CONVERSION I.C. PRODUCTS, page 15-52
- MODERN ELECTRONIC CIRCUITS REFERENCE MANUAL, page 6, I.M.Gottlieb, "CASCODE-Combination of unipolar and bipolar gives desirable amplifying properties",McGraw-Hill, 1980

## Description

This invention relates to an interface circuit for inputting a digital signal to a bipolar integrated circuit, and more particularly to an interface circuit used for TV video reception processing.

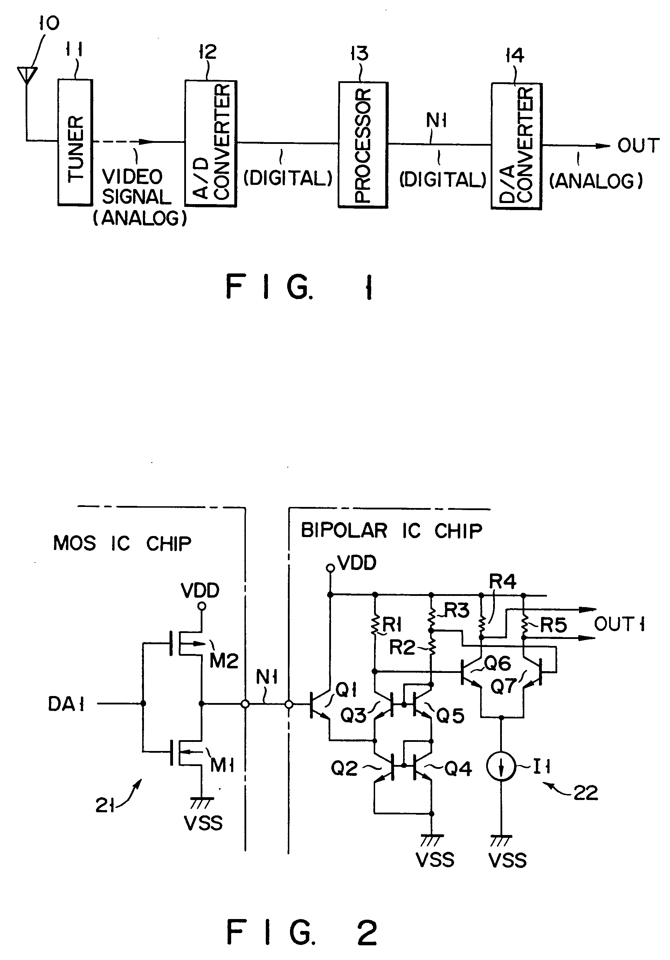

A video reception circuit of Improved Definition TV (IDTV) is constructed as shown in Fig. 1, for example. In the video reception circuit, tuner 11 detects a modulated video signal from a reception signal supplied via antenna 10, A/D converter 12 converts the modulated video signal into a corresponding digital signal, and video processor 13 demodulates the modulated video signal derived from A/D converter 12. The demodulation process includes a process for separating the digital video signal into original color signals of red, green and blue and a process for storing the digital video signal in a memory for each frame unit, for example. D/A converter 14 converts an output signal of video processor 13 into a corresponding analog signal which can be displayed on a display unit. Each function block is formed in the IC configuration and is connected to a corresponding function block.

In a case where video processor 13 and D/A converter 14 are respectively formed as MOS IC and bipolar IC, an interface circuit shown in Fig. 2 is formed in the chip of D/A converter 14, for example. The interface circuit includes bipolar transistors Q1 to Q7, resistors R1 to R5 and constant current source I1, and is connected to video processor 13 via line N1. CMOS circuit 21 constitutes the output section of video processor 13, and sets the potential of line N1 to ground potential level (=0 V) or VDD level (=5 V) according to digital signal DA1. The interface circuit detects the potential of line N1 and supplies output voltage OUT corresponding to the detected potential to D/A converter 14.

When the digital signal is supplied via line N1 which lies outside the MOS IC and bipolar IC chips, harmonics are generated from line N1. When the amplitude of the digital signal is as large as 5 V, the operation of tuner 11 is disturbed by the harmonics generated from line N1, significantly degrading the picture quality.

The Japanese Patent 56-106427 discloses a transistor logical circuit having a TTL input circuit and a level converting circuit in common. In this circuit, an input is directed to the emitter of a switching transistor via a first resistor. The collector of the transistor is connected via a second resistor to a voltage scource. A bias means connected to the voltage source, the base of the transistor, and ground is provided for controlling the base current of the transistor, and accordingly its switching state. However, this transistor logical circuit has the drawback that it is greatly influenced by unwanted harmonics and has a low response speed.

DE 35 18 413 Al discloses an input buffer circuit and a logic circuit arrangement using it. The object on which the subject matter electronical circuit of this document is based on, is to decrease a power consumption of such a circuit and simultaneously increase its processing speed.

The circuit of this document comprises a switching transistor which has its emitter connected to an input terminal. The collector of the transistor is connected to a reference potential via a voltage divider comprising two serially arranged resistors. In parallel to the voltage divider, there is arranged a transistor which has its base and collector short-circuited as a diode means. A bias means including another transistor and a current source are used to control the base current of the switching transistor in a feedback manner. In particular, the other transistor has its base connected to the node between the two resistors of the voltage divider, its collector to the reference voltage, and its emitter to the base of the switching transistor and to one end of the current scource, the other end of the current source being held at a predetermined potential.

However, this circuit according to that document has the important disadvantage that the base current of the central switching transistor which controlled in a feedback manner via the bias means which senses the collector current of said switching transistor is influenced by the operation of said diode means. Therefore, the switching of this diode means which determines the lower level of the output signal also influences the base control of the switching transistor making easier a decrease into the low output level, however, has the disadvantage of contributing to unwanted harmonics.

Moreover, the switching interval of a circuit using the above mentioned feedback manner is considerably broadened. Furthermore, the circuit of this document tends to produce overvoltage output signals. This makes necessary the introduction of further electronic components in order to compensate the above-mentioned drawbacks. However, this makes the circuit large and unpracticable.

The object of this invention is to provide an interface circuit capable of suppressing generation of harmonics and having a fast response speed.

This object can according to claim 1 be attained by an interface circuit comprising
an input terminal;
a ground terminal;
a power source terminal set at a positive potential with respect to the potential of the ground terminal;
an NPN transistor having a base, a collector and an emitter;
a second resistor means connected between the collector of said NPN transistor and said power source terminal;
a diode means connected in forward direction between said power source terminal and the collector of said NPN transistor; and
a bias means to control the base current of said NPN transistor;
**characterized** in that:
a first resistor means is connected between the emitter of said NPN transistor and said input terminal;
said bias means includes a voltage divider which is connected between said power source terminal, said base of the said NPN transistor, and said ground terminal to control the base current of said NPN transistor by applying a predetermined base potential; and
said interface circuit further comprises:
a third resistor means connected between the emitter of said NPN transistor and said ground terminal for inhibiting the emitter current of said NPN transistor from being cut off.

Preferred embodiments are listed in dependent claims 2 to 5.

With the above interface circuit, whether the input terminal is grounded or not can be detected based on the collector current of the NPN transistor. The output potential derived from the collector of the NPN transistor is set to substantially the same potential of the power source terminal when it is detected that the input terminal is set in the high impedance condition, and set to a potential level lower than the potential of the power source terminal when it is detected that the input terminal is set in the grounded condition. The potential of the input terminal is slightly changed with variation thereof from one condition to the other. In this case, it is not necessary to detect the potential variation as a digital signal and the potential variation will not be so large as to incur harmonics. Therefore, when the interface circuit is used for TV video reception processing, the degradation in the picture quarity due to harmonics can be suppressed.

This invention can be more fully understood from the following detailed description when taken in conjunction with the accompanying drawings, in which:
Fig. 1 is a block diagram schematically showing a video reception circuit of Improved Definition TV (IDTV);
Fig. 2 is a circuit diagram showing the conventional interface circuit for supplying an output signal of the video processor of Fig. 1 to a D/A converter;
Fig. 3 is a circuit diagram showing an interface circuit; and
Fig. 4 is a circuit diagram showing an interface circuit according to an embodiment of this invention which is obtained by improving the response characteristic of the interface circuit of Fig. 3.

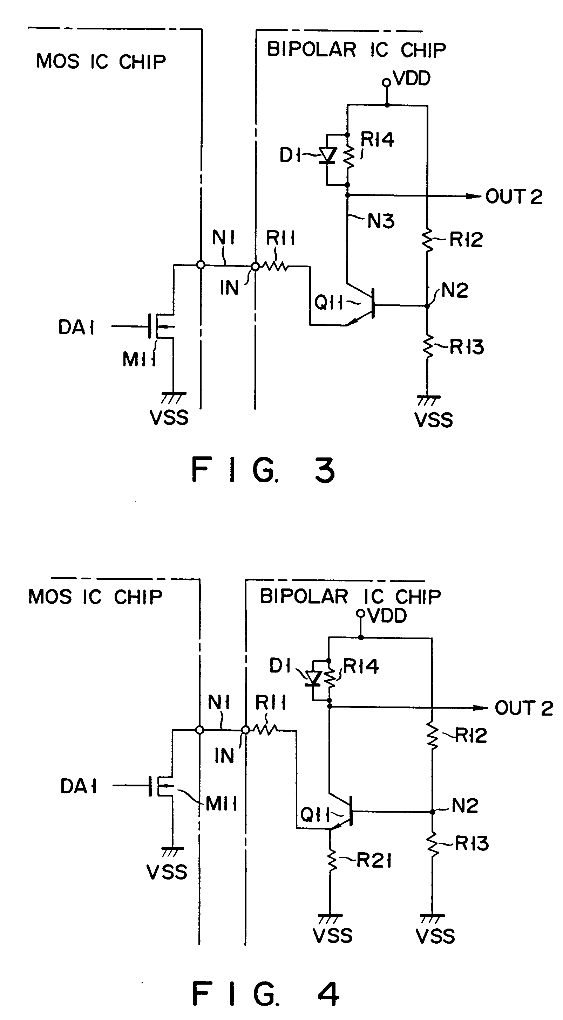

Now, an interface circuit is explained with reference to Fig. 3. The interface circuit is used for supplying an output signal of video processor 13 to D/A converter 14 in the video reception circuit of Improved Definition TV (IDTV) shown in Fig. 1, for example. In this case, the interface circuit is formed in the bipolar IC chip of D/A converter 14 as in the prior art case.

The interface circuit includes input terminal IN, resistors R11 to R14, NPN transistor Q11, diode D1, power source terminal VDD and ground terminal VSS. Power source terminal VDD and ground terminal VSS are respectively set at potentials of VDD level (=5 V) and VSS level (=0 V). Resistor R11 is connected between input terminal IN and the emitter of NPN transistor Q11, resistors R12 and R13 are serially connected between power source terminal VDD and ground terminal VSS. The base of NPN transistor Q11 is connected to a connection node between resistors R12 and R13. Resistor R14 is connected between the collector of NPN transistor Q11 and power source VDD, and diode D1 is connected in a forward direction between power source terminal VDD and the collector of NPN transistor Q11. The collector of NPN transistor Q11 serves as output terminal OUT2 of the interface circuit. The resistances of resistors R11, R12, R13 and R14 are respectively set at 1 KΩ, 3.3 KΩ, 1.7 KΩ and 700Ω.

In a case where the interface circuit is formed with the above construction, n-channel MOS transistor M11 is formed in a MOS IC chip of video processor 13. The current path of MOS transistor M11 is connected between input terminal IN and ground terminal VSS, and the gate of MOS transistor M11 is supplied with digital signal DA1. MOS transistor M11 selectively connects input terminal IN to the ground terminal according to digital signal DA1 so as to supply digital signal DA1 to the interface circuit.

In operation, when digital signal DA1 is set at the ground potential level, MOS transistor M11 is set in the non-operative condition to prevent current from flowing in transistor Q11. At this time, the potential of node N3 is set at substantially the VDD level, and the potential of input terminal IN is set to a potential level (=1 V) less than the base potential (=1.7 V) of transistor Q11 by base-emitter voltage VBE (=0.7 V). When the gate potential of MOS transistor M11 rises, MOS transistor M11 is turned on to lower the potential of input terminal IN.

When the potential of input terminal IN becomes 0.5 V, the following current flows in transistor Q11:$\text{(1 [V] - 0.5 [V])/R11 = 0.5 [V]/1 [kΩ] = 500 [µA]}$

At this time, the potential of node N3 becomes as follows:$\text{VDD - R14 × 500 [µA] = 5 [V] - 700 [Ω] × 500 [µA] = 4.65 [V]}$

If the gate potential of MOS transistor M11 further rises, the potential of input terminal IN becomes substantially 1 V, causing a current of 1 mA to flow in transistor Q11. At this time, the potential of node N3 is clamped by forward voltage VF (= 0.7 V) of diode D1 and set to the following potential level :$\text{VDD - VF = 5 - 0.7 = 4.3 [V]}$

That is, the potential of node N3 varies from 4.3 V to 5 V. Therefore, only if the threshold voltage of D/A converter 14 is set to an intermediate potential level (=4.6 V) of the potential variation range, digital signal DA1 may be correctly transmitted to D/A converter 14.

In this interface circuit, the potential of input terminal IN varies from 0 V to 1 V, and the variation is so small that occurrence of harmonics can be sufficiently suppressed. As a result, degradation of the picture quality can be prevented.

The interface circuit includes transistor Q11 which is set into the cut-off condition. Since the switching time of transistor Q11 depends on the stray capacitance of the current path including transistor Q11, the interface circuit cannot sometimes operate at such a sufficiently high speed as to correctly respond to digital signal DA1 of high bit rate.

Fig. 4 shows the construction of an interface circuit according to an embodiment of this invention. The interface circuit is similar to that of Fig. 3 except that resistor R21 is additionally connected between the emitter of transistor Q11 and ground terminal VSS. The resistance of resistor R21 is 5 KΩ, for example. Resistor R21 is used to always supply a current to transistor Q11 so as not to completely turn off transistor Q11. In this case, the response characteristic of the interface can be improved over that of the interface of Fig.3.

This invention as defined by the Claims can be variously modified. In the above embodiments, the interface circuit is used to supply an output signal of the MOS IC to the bipolar IC. However, it is possible to use the interface circuit so as to supply an output signal of the bipolar IC to another bipolar IC. In this case, an open-collector output type bipolar transistor is formed in the bipolar IC chip instead of open-drain output type MOS transistor M11 formed in the MOS IC chip, and is connected to the interface circuit.

Further, the interface circuit of the above embodiment can be operated in response to digital signal DA1 supplied via CMOS circuit 21 shown in Fig. 2. Therefore, if it is not necessary to suppress occurrence of harmonics, the interface circuit may be connected to CMOS circuit 21 shown in Fig. 2.

## Claims

1. An interface circuit comprising:
an input terminal (IN);
a ground terminal (VSS);
a power source terminal (VDD) set at a positive potential with respect to the potential of the ground terminal (VSS);
an NPN transistor (Q11) having a base, a collector and an emitter;
a second resistor means (R14) connected between the collector of said NPN transistor (Q11) and said power source terminal (VDD);
a diode means (D1) connected in forward direction between said power source terminal (VDD) and the collector of said NPN transistor (Q11); and
a bias means (R12, R13) to control the base current of said NPN transistor;
**characterized** in that:
a first resistor means (R11) is connected between the emitter of said NPN transistor (Q11) and said input terminal (IN);
said bias means includes a voltage divider (R12, R13) which is connected between said power source terminal (VDD), said base of the said NPN transistor (Q11), and said ground terminal (VSS) to control the base current of said NPN transistor (Q11) by applying a predetermined base potential; and
said interface circuit further comprises:
a third resistor means (R21) connected between the emitter of said NPN transistor (Q11) and said ground terminal (VSS) for inhibiting the emitter current of said NPN transistor (Q11) from being cut off.

2. An interface circuit according to claim 1, characterized in that said terminals (IN, VDD, VSS), said NPN transistor (Q11), said diode means (D1), and said first to third resistor means (R11, R14, R21) are formed in one IC chip, and said interface circuit further comprises a switching means (M11) formed in another IC chip different from said one IC chip and connected between said input terminal (IN) and said ground terminal (VSS) for selectively grounding said input terminal (IN).

3. An interface circuit according to claim 2, characterized in that said switching means is an open-drain output type MOS transistor (M11).

4. An interface circuit according to claim 1, 2, or 3, characterized in that said voltage divider (R12, R13) is a linear voltage divider.

5. An interface circuit according to claim 4, characterized in that said voltage divider includes a fourth resistor means (R13) grounded at one end and a fifth resistor means (R12) connected between the other end of said fourth resistor means (R13) and said power source terminal (VDD), and the base of said NPN transistor (Q11) is connected to a connection node between said fourth and fifth resistor means (R12, R13).

## Patentansprüche

1. Schnittstellenschaltung mit:
einem Eingabeanschluß (IN);
einem Masseanschluß (VSS);
einem Leistungsquellenanschluß (VDD), eingestellt auf ein positives Potential bezüglich dem Potential des Masseanschlusses (VSS);
einen NPN-Transistor (Q11) mit einer Basis, einem Kollektor und einem Emitter;
einer zweiten Widerstandseinrichtung (R14) angeschlossen zwischen dem Kollektor des NPN-Transistors (Q11) und dem Leistungsquellenanschluß (VDD);
einer Diodeneinrichtung (D1), angeschlossen in Vorwärtsrichtung zwischen dem Leistungsquellenanschluß (VDD) und dem Kollektor des NPN-Transistors (Q11); und
einer Vorspannungseinrichtung (R12, R13) zum Steuern des Basisstroms des NPN-Transistors;
dadurch **gekennzeichnet**, daß
eine ersten Widerstandseinrichtung (R11) angeschlossen ist zwischen dem Emitter des NPN-Transistors (Q11) und dem Eingabeanschluß (IN);
die Vorspannungseinrichtung einen Spannungsteiler (R12, R13) beinhaltet, welcher angeschlossen ist zwischen dem Leistungsquellenanschluß (VDD), der Basis des NPN-Transistors (Q11) und den Masseanschluß (VSS), um den Basisstrom des NPN-Transistors (Q11) durch Anlegen eines vorbestimmten Basispotentials zu steuern; und
wobei die Schnittstellenschaltung weiterhin umfaßt:
eine dritte Widerstandseinrichtung (R21), angeschlossen zwischen dem Emitter des NPN-Transistors (Q11) und dem Masseanschluß (VSS) zum Verhindern, daß der Emitterstrom des NPN-Transistors (Q11) abgeschnitten wird.

2. Schnittstellenschaltung nach Anspruch 1, dadurch gekennzeichnet, daß die Anschlüsse (IN, VDD, VSS), der NPN-Transistor (Q11), die Diodeneinrichtung (D1), und die erste bis dritte Widerstandseinrichtung (R11, R14, R21) in einem IC-Chip gebildet sind, und daß die Schnittstellenschaltung weiterhin eine Schalteinrichtung (M11) umfaßt, die in einem weiteren IC-Chip gebildet ist, der verschieden ist von dem einen IC-Chip, und angeschlossen ist zwischen dem Eingabeanschluß (IN) und dem Masseanschluß (VSS) zum selektiven Legen des Eingabeanschlusses (IN) auf Masse.

3. Schnittstellenschaltung nach Anspruch 2, dadurch gekennzeichnet, daß die Schalteinrichtung ein Offen-Drain-Ausgabe-Typ MOS-Transistor (M11) ist.

4. Schnittstellenschaltung nach Anspruch 1, 2 oder 3, dadurch gekennzeichnet, daß der Spannungsteiler (R12, R13) ein linearer Spannungsteiler ist.

5. Schnittstellenschaltung nach Anspruch 4, dadurch gekennzeichnet, daß der Spannungsteiler eine vierte Widerstandseinrichtung (R13) beinhaltet, die an einem Ende auf Masse gelegt ist, und eine fünfte Widerstandseinrichtung, (R12), die angeschlossen ist zwischen dem anderen Ende der vierten Widerstandseinrichtung (R13) und dem Leistungsquellenanschluß (VDD), und daß die Basis des NPN-Transistors (Q11) angeschlossen ist zwischen einem Verbindungsknoten der vierten und fünften Widerstandseinrichtung (R12, R13).

## Revendications

1. Circuit d'interface comprenant :
une borne d'entrée (IN) ;
une borne de masse (VSS) ;
une borne d'alimentation (VDD) mise à un potentiel positif par rapport au potentiel de la borne de masse (VSS) ;
un transistor NPN (Q11) ayant une base, un collecteur et un émetteur ;
un second dispositif de résistance (R14) relié entre le collecteur dudit transistor NPN Q11 et ladite borne d'alimentation (VDD) ;
un dispositif de diode (D1) relié dans le sens direct entre ladite borne d'alimentation (VDD) et le collecteur dudit transistor NPN (Q11) ; et
un dispositif de polarisation (R12, R13) pour commander le courant de base dudit transistor NPN ;
caractérisé en ce que :
un premier dispositif de résistance (R11) est relié entre l'émetteur dudit transistor NPN (Q11) et ladite borne d'entrée (IN) ;
ledit dispositif de polarisation comprend un diviseur de tension (R12, R13) qui est relié entre ladite borne d'alimentation (VDD), ladite base dudit transistor NPN (Q11) et ladite borne de masse (VSS) pour commander le courant de base dudit transistor NPN (Q11) en appliquant un potentiel de base prédéterminé ; et
ledit circuit d'interface comprend en outre :
un troisième dispositif de résistance (R21) relié entre l'émetteur dudit transistor NPN (Q11) et ladite borne de masse (VSS) pour interdire le courant d'émetteur dudit transistor NPN (Q11) d'être bloqué.

2. Un circuit d'interface selon la revendication 1, caractérisé en ce que lesdites bornes (IN, VDD, VSS), ledit transistor NPN (Q11), ledit dispositif de diode (D1), et lesdits premier au troisième dispositifs de résistance (R11, R14, R21) sont formés dans une puce de circuit intégré, et ledit circuit d'interface comprend en outre un dispositif de commutation (M11) formé dans une autre puce de circuit intégré différente de ladite une puce de circuit intégré et relié entre ladite borne d'entrée (IN) et ladite borne de masse (VSS) pour mettre à la masse sélectivement ladite borne d'entrée (IN).

3. Circuit d'interface selon la revendication 2, caractérisé en ce que ledit dispositif de commutation est un transistor MOS du type à sortie à drain ouvert (M11).

4. Circuit d'interface selon la revendication 1, 2, ou 3, caractérisé en ce que ledit diviseur de tension (R12, R13) est un diviseur de tension linéaire.

5. Circuit d'interface selon la revendication 4, caractérisé en ce que ledit diviseur de tension comprend un quatrième dispositif de résistance (R13) relié à la masse à une extrémité et un cinquième dispositif de résistance (R12) relié entre l'autre extrémité dudit quatrième dispositif de résistance (R13) et ladite borne de source d'alimentation (VDD) et la base dudit transistor NPN (Q11) est reliée à un noeud de connexion entre lesdits quatrième et cinquième dispositifs de résistance (R12, R13).
